# EUROPEAN PATENT SPECIFICATION

(11) **EP 0 798 564 B1**
(45) Date of publication and mention of the grant of the patent: **21.05.2003**
(21) Application number: 97400451.7
(22) Date of filing: 27.02.1997
(51) Int. Cl.: G01R 11/04, G01R 1/04

(54) **Housing for an electricity meter**
Gehäuse für einen Elektrizitätszähler
Boîtier pour un compteur d'électricité

(30) Priority: 29.03.1996 DE 29605862 U
(43) Date of publication of application: 01.10.1997
(73) Proprietor: AEG Zähler GmbH, 31785 Hameln (DE)
(72) Inventor: Hüskes, Rudi, 31020 Salzhemmendorf (DE); Neumann, Bernhard, 31863 Coppenbrügge (DE)
(74) Representative: Feray, Valérie

(56) References cited:
- EP-A- 0 531 555
- DE-A- 4 230 236

## Description

Electricity meters conventionally comprise a housing consisting of a box-shaped base having a mounting block for mounting the metrology elements of the meter together with a cover placed above and adapted to close the base. The sealable cover, which is fitted against an outer edge of the base plate, protects the metering arrangement of the meter against unauthorised access as well as acting to prevent entry of dust and water. For this purpose, the join between the base plate and the cover is normally provided with a seal, for example a rubber element, which is simply inserted or fixed in place with an adhesive around the edge of the join.

An additional seal of this type, however, involves a significant manufacturing effort. Furthermore, problems often occur when the sealing material adheres to both parts (cover and base) of the housing. This may arise, for example, when the electricity meter is opened for the first time after many years for testing or adjustment.

The document EP-A-053 155 discloses a housing for an electrical apparatus comprising a first housing part in the form of a box-shaped base, and a second housing part in the form of a separate cover which closes the base, a join around the edges of said base and said cover being formed by the contact between the engaging faces of the cover and base, wherein the engaging face of the first housing part is moulded with one slot, whilst the engaging face of the second housing part is moulded with a projecting resilient element, said slot and resilient element running around the periphery of the housing and engaging each other when the housing parts are closed so as to define a free space between the engaging faces of the parts.

The present invention has the object of providing, in an electricity meter of the above-mentioned type, a join between base plate and cover in such manner that the housing is adequately protected against entry of dust and water or humidity, in conformance with the appropriate regulations and norms, but without the use of any further sealing material.

This problem is solved by means of a housing having the characteristics of Claim 1. Further embodiments and preferred implementations of the invention are stated in the subclaims.

The invention possesses the advantage that no further sealing material is required, a good sealing effect being achieved merely due to the position and form of the engaging faces of the base and cover.

In particular, the form of the base and cover are such that these parts of the housing engage each other in order that a channel or free space exists in the join between the base and the cover, said channel being provided with drainage openings harnlessly draining any moisture which may penetrate the join.

Furthermore, no additional tooling effort is required for manufacturing the components of the housing, and normal moulding processes can be employed.

An embodiment of the invention will now be described by way of example only and with reference to the attached figures, in which :
Fig. 1 represents the open face of a meter base in which is moulded a terminal block ;
Fig. 2 shows a detail II of Fig.1 ;
Fig. 3 shows a detail III of Fig.1, to a larger scale ;
Fig. 4 is an enlarged cross-section through the upper region of the closed housing ; and
Fig. 5 shows a detail V of Fig. 4 to larger scale.

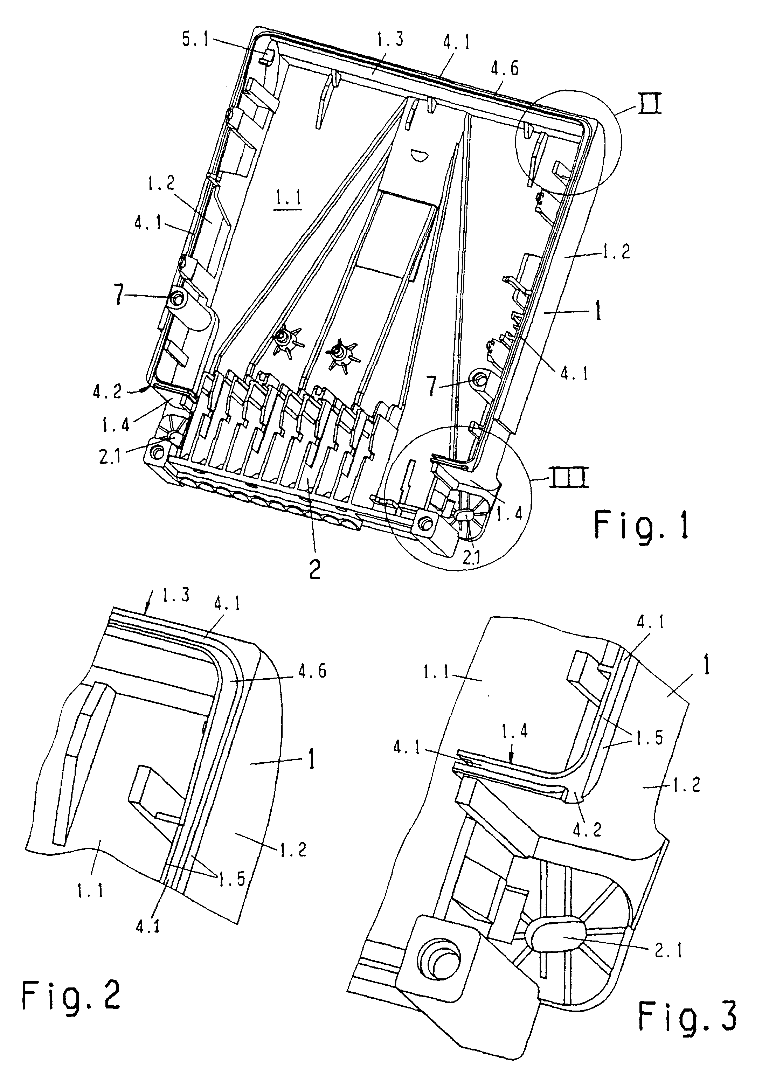

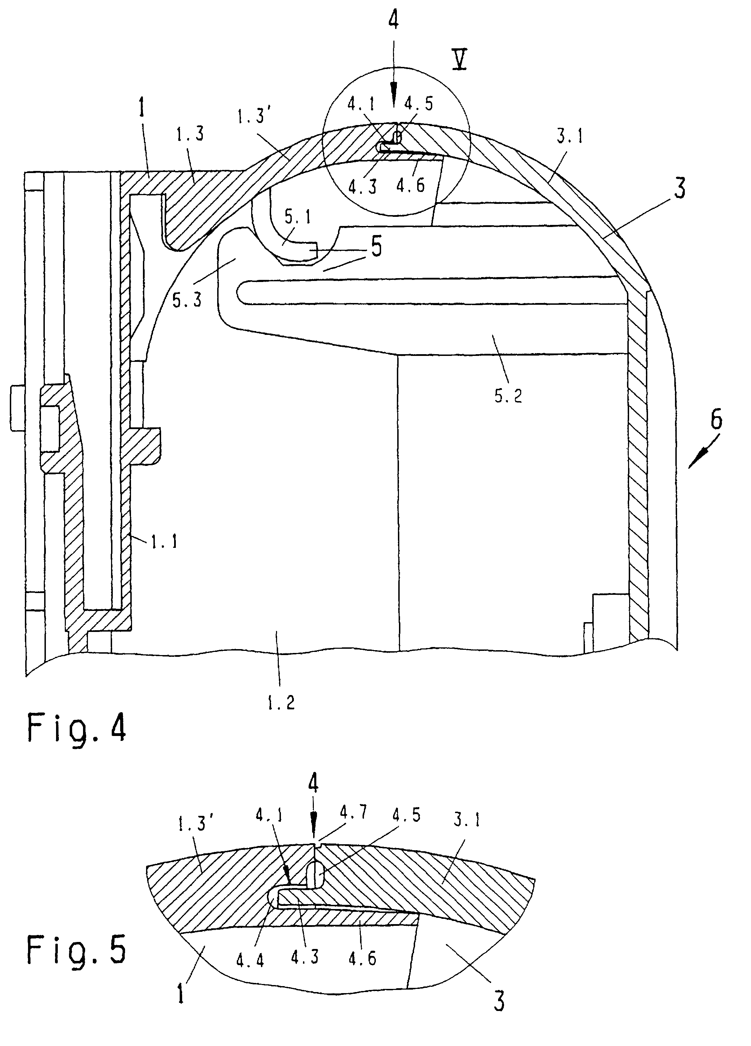

The box-shaped base 1 which is shown in front elevation in Fig. 1 is preferably made of a thermoplastic material and has a rear panel 1.1 provided on both sides with side panels 1.2 projecting preferably at right angles to the rear panel. The upper side of the base is terminated by means of an upper terminating panel 1.3, which is arranged to rise towards the open face, and which preferably has a curved profile, as may be seen from the cross-section of Fig. 4. In the normal working position of the electricity meter, a one-piece terminal block 2 is moulded in the base, opposite the upper panel. This terminal block is covered by a bridge piece (not shown) which forms a bulkhead between two lower panel sections 1.4. The upper terminating panel 1.3, both side panels 1.2 and the bottom panel sections 1.4 are preferably arranged to have the same height. Together with the rear panel, these form a box-shaped space for housing the metering arrangement or metrology elements of the meter (not shown).

Base plate 1 is covered by means of an approximately equal sized cover 3 (Fig. 4), which protectively encloses the metering arrangement all round, once the cover has been placed on the panel parts 1.2, 1.3, 1.4 of the base plate. The cover is also domed on its upper side. Thus, between the engaging faces of the panel parts of the base and the cover, a frame-like join 4 is produced. The shape of this join is central to the invention. The join includes a slot 4.1 which is formed around the periphery of the base 1, in the end faces 1.5 of panels 1.2, 1.3 and 1.4. The cross-section of the slot 4.1 may be seen in Fig. 4 and Fig. 5, and its relative position in Figs. 1 to 3. The slot 4.1 is provided with drain openings 4.2 on the lower part of the base, and on either side of the terminal block 2. That is, in those positions the slot continues freely outwards as a continuation of the panels 1.2. See Fig. 3.

A projecting resilient element 4.3, which also runs around the periphery of the join, is provided on cover 3, said resilient element 4.3 engaging with the slot 4.1. The resilient element 4.3 enters the slot 4.1 in such manner that a channel or free space 4.4 remains between the bottom of slot 4.1 and the edge of the element 4.3. This channel or free space is in addition to the normal necessary sideways play provided between parts of the housing to allow for manufacturing tolerances and possible temperature expansion in the parts and is part of the design. See Fig. 5. Any moisture penetrating into the join 4 from the outside can therefore be collected in the free space 4.4 and can be guided around the base plate in order to be drained at the two drain openings 4.2. Preferably, a further channel or free space 4.5 is provided, moulded as a small groove in the mating faces 4 of the cover and in the panel parts of the base. This groove in each of the parts of the housing is shown in Fig. 5. The second channel 4.5 is arranged exterior of the slot 4.1 and the resilient element 4.3 and continues around the periphery of the housing in parallel with these. This second channel further improves the drainage of moisture penetrating into the mating faces.

Furthermore, there is provided an elastically flexible sealing lip 4.6 at the end panel 1.3 of the base plate 1. This sealing lip 4.6 forms the inner termination of the join at the top of the housing. Its shape is shown in Figure 4, and in enlarged form in Figure. 5. In both these cross-sectional drawings the curved section or dome 3.1 at the top of cover 3 may be easily recognised, said dome merging into the corresponding dome 1.3' of the base plate. The dome shape is slightly interrupted in the region of the join 4 by means of a so-called shadow gap 4.7. It is important that the sealing lip 4.6 should be biased to press against the inside of dome 3.1. See Fig. 5.

Pressing the sealing lip 4.6 against cover 3 is facilitated by a hinge arrangement 5, said hinge arrangement consisting of a hook 5.1 on base plate 1 and a tongue 5.2 on cover 3. When cover 3 is swung in a closing direction, as indicated in the direction of arrow 6 shown in Fig. 4, a projection 5.3 of the tongue 5.2 engages the hook 5.1 in order to ensure that, after the housing has been closed, a firm mutual contact exists between base plate 1 and cover 3 in the region of the join 4. The closed position is completely secured by two sealing screws passing through the cover, the screw holes 7 being arranged on both side panels of base plate 1. See Fig. 1.

In its normal operating position at its place of utilisation, the housing of the electricity meter is hung on a vertical surface by its rear panel 1.1, preferably on a meter panel or in a meter cubicle, by means of a three-point suspension. The two lower mounting points 2.1 are visible in Fig. 1 and Fig. 3. A third mounting point may be provided by a frame external of the housing (not shown). The domed sections 1.3' and 3.1 of the base and cover form the top of the housing, with the join 4 being at the highest point. Moisture arriving from the outside, in particular water falling on the meter from above, will therefore run off mainly along the outside surfaces. If, eventually, a certain quantity of moisture should penetrate into the join 4, then said moisture will run off in the free space 4.5 and in the channel 4.4 around the inside of the housing, thereafter escaping downwards at the two drain openings 4.2. In this regard, the sealing lip 4.6, which is continued from the upper end panel 1.3 around each corner to reach the side walls 1.2 serves to provide an additional sealing function at a critical point. See Fig. 2. Furthermore, the resilient element 4.3 enters into the slot 4.1 in such a manner that any misalignment between the panel parts of the base plate and the corresponding panel parts of the cover is avoided. Consquently, the metering arrangement, which is contained within the housing, is adequately protected against entry of moisture and dust.

In alternative embodiments of the invention it is also possible to form the base plate and the cover at the top in the form of a gabled roof, instead of a dome. In the same way, interchange of the location of the slot and resilient element, and of further elements of the mating faces, between the base plate and the cover can be readily considered to lie within the scope of the invention.

## Claims

1. A housing for an electricity meter comprising a first housing part in the form of a box-shaped base, and a second housing part in the form of a separate cover which closes the base, a join around the edges of said base and said cover being formed by the contact between the engaging faces of the cover and base, wherein:
a) the engaging face (4) of one of the housing parts (1) is moulded with at least one slot (4.1), whilst the engaging face of the other housing part (3) is moulded with a projecting resilient element (4.3), said slot and resilient element running around the periphery of the housing and engaging each other when the housing parts (1,3) are closed so as to define a channel or free space (4.4) between the engaging faces of the parts; **characterised in that** :
b) the rear panel is arranged for mounting on a vertical surface
c) the channel or free space (4.4) is provided with drainage openings (4.2) as continuations of the respective vertical sideways engaging faces (4) towards the bottom of the electricity meter; and
d) on the uppermost side of the housing, there is provided on one housing part (1) an elastically flexible sealing lip (4.6), which presses against the other housing part (3) beneath the engaging faces of the housing parts after the housing has been closed.

2. A housing in accordance with claim 1, **characterised in that** the slot (4.1) and the sealing lip (4.6) are directly moulded on the thermoplastic base plate (1) and the resilient element (4.3) on the cover (3).

3. A housing in accordance with claims 1 and 2, **characterised in that** a further space (4.5) is formed around the engaging faces of the housing parts in the form of a groove in each part, said further free space (4.5) being formed between the outside of the housing and the channel (4.4) formed by the slot (4.1) and resilient element (4.3) and also ending in the tower drainage openings (4.2).

4. A housing in accordance with claims 1 to 3, **characterised in that** the cover (3) is hinged to the top of the base (1) by means of a separable hinge arrangement (5) and **in that** said cover (3) is capable of being hinged against the flexible sealing lip (4.6) with the inner surface of its uppermost section when the two housing parts (1.3) are closed.

5. A housing in accordance with any of claims 1 to 4, **characterised in that** the base (1) and the cover (3) are formed so as to provide a gabled or domed roof on the uppermost side of the housing, the mating faces of the base and cover which cooperate to form the join being arranged at the highest point of the dome or roof.

## Patentansprüche

1. Gehäuse für einen Stromzähler mit einem ersten als kastenförmigen Untersatz ausgebildeten Gehäuseteil und einem zweiten, als getrennten Deckel ausgebildeten Gehäuseteil, welches den Untersatz verschließt, wobei eine Verbindung um die Kanten des besagten Untersatzes und des besagten Deckels herum durch den Kontakt zwischen den ineinandergreifenden Seiten des Deckels und des Untersatzes gebildet wird, worin:
a) die greifende Seite (4) eines der Gehäuseteile (1) mit mindestens einem Schlitz (4.1) geformt ist, wobei die greifende Seite des anderen Gehäuseteils (3) mit einem vorstehenden, schlagfesten Element (4.3) geformt ist, wobei der besagte Schlitz und das schlagfeste Element, welche um die Peripherie des Gehäuses herum verlaufen und ineinander greifen, wenn die Gehäuseteile (1, 3) so verschlossen sind, dass sie zwischen den ineinandergreifenden Seiten der Teile einen Kanal oder Freiraum (4.4) bilden, **dadurch gekennzeichnet, dass**
b) die hintere Platte zum Einbau auf einer senkrechten Fläche angebracht ist,
c) der Kanal oder Freiraum (4.4) mit Dränungsöffnungen (4.2) als Verlängerungen der jeweiligen senkrechten, seitlich ineinandergreifenden Seiten (4) zum unteren Teil des Stromzählers hin versehen sind, und
d) an der obersten Seite des Gehäuses, auf einem Gehäuseteil (1) eine elastisch flexible Dichtungslippe (4.6) vorgesehen ist, welche nach Verschließung des Gehäuses auf dem anderen Gehäuseteil (3) unter den ineinandergreifenden Seiten der Gehäuseteile andrückt.

2. Gehäuse nach Anspruch 1, **dadurch gekennzeichnet, dass** der Schlitz (4.1) und die Dichtungslippe (4.6) formschlüssig auf dem thermoplastischen Untersatz (1) geformt sind und das schlagfeste Element (4.3) auf dem Deckel (3).

3. Gehäuse nach den Ansprüche 1 und 2, **dadurch gekennzeichnet, dass** ein weiterer Raum (4.5) um die ineinandergreifenden Seiten der Gehäuseteile herum durch eine Rille in jedem Teil ausgebildet ist, wobei dieser besagte weitere Raum (4.5) zwischen der Außenseite des Gehäuses und dem durch den Schlitz (4.1) und dem schlagfesten Element (4.3) gebildeten Kanal (4.4) ausgebildet ist und auch in den unteren Dränungsöffnungen (4.2) endet.

4. Gehäuse nach den Ansprüchen 1 bis 3, **dadurch gekennzeichnet, dass** der Deckel (3) mittels einer trennbaren Scharniervorrichtung (5) an der Oberseite des Untersatzes (1) eingehängt ist und dass der besagte Deckel (3) geeignet ist, mit der Innenseite seines obersten Abschnitts gegen die flexible Dichtungslippe (4.6) eingehängt zu werden, wenn die beiden Gehäuseteile (1.3) verschlossen sind.

5. Gehäuse nach einem der Ansprüche 1 bis 4, **dadurch gekennzeichnet, dass** der Untersatz (1) und der Deckel (3) so ausgebildet sind, dass sie ein gegiebeltes oder gewölbtes Dach auf der obersten Seite des Gehäuses bilden, wobei die zusammengehörigen Seiten des Untersatzes und des Deckels, welche zusammenwirken, um die Verbindung zu bilden, am höchsten Punkt des Gewölbes oder Daches angebracht sind.

## Revendications

1. Logement pour un compteur d'électricité comprenant une première partie de logement sous forme d'une base en forme de boîte et une seconde partie de logement sous forme d'un couvercle séparé qui ferme la base, un joint étant formé autour des bords de ladite base et dudit couvercle par le contact entre les faces d'engagement du couvercle et de la base, dans lequel :
a) la face d'engagement (4) de l'une des parties de logement (1) est moulée avec au moins une fente (4.1) tandis que la face d'engagement de l'autre partie de logement (3) est moulée avec un élément souple projeté (4.3), ladite fente et ledit élément souple tournant autour de la périphérie du logement et s'engageant mutuellement lorsque les parties de logement (1, 3) sont fermées de façon à définir un canal ou espace libre (4.4) entre les faces d'engagement des parties ; **caractérisé en ce que** :
b) le panneau arrière est disposé de façon à être monté sur une surface verticale ;
c) le canal ou espace libre (4.4) est doté d'ouvertures d'évacuation (4.2) faisant office de continuation des côtés verticaux respectifs des faces d'engagement (4) vers le bas du compteur d'électricité ; et
d) sur le côté supérieur du logement, est fournie sur une partie de logement (1) une lèvre d'étanchéité élastiquement flexible (4.6) qui s'appuie contre l'autre partie de logement (3) en dessous des faces d'engagement des parties de logement une fois que le logement a été fermé.

2. Logement selon la revendication 1, **caractérisé en ce que** la fente (4.1) et la lèvre d'étanchéité (4.6) sont directement moulées sur la plaque à base de thermoplastique (1) et l'élément flexible (4.3) sur le couvercle (3).

3. Logement selon les revendications 1 et 2, **caractérisé en ce qu'**un espace supplémentaire (4.5) est formé autour des faces d'engagement des parties de logement sous la forme d'une gorge dans chaque partie, ledit espace libre supplémentaire (4.5) étant formé entre l'extérieur du logement et le canal (4.4) formé par la fente (4.1) et l'élément flexible (4.3) et se terminant également dans les ouvertures d'évacuation (4.2) situées en contrebas.

4. Logement selon les revendications 1 à 3, **caractérisé en ce que** le couvercle (3) est encharné au niveau du haut de la base (1) au moyen d'un système de charnière séparable (5) et **en ce que** ledit couvercle (3) peut être encharné contre la lèvre d'étanchéité flexible (4.6) avec la surface interne de sa partie supérieure lorsque les deux parties de logement (1, 3) sont fermées.

5. Logement selon l'une quelconque des revendications 1 à 4, **caractérisé en ce que** la base (1) et le couvercle (3) sont formés de façon à fournir un toit à pignon ou en dôme sur le côté supérieur du logement, les faces correspondantes de la base et du couvercle qui coopèrent pour former le joint étant placées au point le plus élevé du dôme ou du toit.
